Europäisches Patentamt

European Patent Office

Office européen des brevets

(11) Publication number : **0 475 753 A2**

## (12) EUROPEAN PATENT APPLICATION

(21) Application number : **91308320.0**

(22) Date of filing : **11.09.91**

(51) Int. Cl.$^5$ : **C04B 35/00, H01L 39/24**

(30) Priority : **12.09.90 US 581324**

(43) Date of publication of application :
**18.03.92 Bulletin 92/12**

(84) Designated Contracting States :
**AT BE CH DE DK ES FR GB GR IT LI LU NL SE**

(71) Applicant : **UNIVERSITY OF ARKANSAS**
**P.O. Box 3017**
**Little Rock, Arkansas 72203 (US)**

(72) Inventor : **Zhengzhi, Sheng**
**Rt.5,Box 144**
**Fayetteville, Arkansas 72701 (US)**
Inventor : **Measson, John**
**Ss102 Carlson Terrace**
**fayetteville,Arkansas 72701 (US)**
Inventor : **Xin, Ying**
**F-203 Carlson Terrace**
**Fayetteville, Arkansas 72701 (US)**

(74) Representative : **Sheard, Andrew Gregory et al**
**Kilburn & Strode 30, John Street**
**London WC1N 2DD (GB)**

(54) **M-R-Tl-Sr-Cu-O based superconductors above liquid nitrogen temperature and processes for making them.**

(57)    A high temperature superconducting system is disclosed which comprises the compound M-R-Tl-Sr-Cu-O where M represents at least one of the elements Hg, Pb, K and/or Al and R represents a rare earth metal such as Pr. One composition forming a 93K superconducting phase has Hg or Al. Another composition comprises M-R-Tl-Sr-Cu-O where M is Pb and/or K and has a superconducting phase at 100K.

EP 0 475 753 A2

The present invention relates to high temperature superconducting systems and to processes for making them.

A variety of high temperature superconducting systems have been developed. Such superconducting systems include:

Y-Ba-Cu-O; Bi-Sr-Ca-Cu-O; Tl-Ba-Cu-O; and Tl-Ba-Ca-Cu-O. A number of such systems are set forth in pending patent applications of which one of the inventors of the present invention is a co-inventor.

For example, EP-A-0324661 (inventors Z.Z. Sheng and A.M. Hermann) discloses Tl-Ba-Ca-Cu-O superconductors and processes for their preparation. EP-A-0324660 (inventors Z.Z. Sheng and A.M. Hermann) discloses TlBaCuO superconductors and processes for making them. This application also discloses TlSrBaCuO superconductors and processes for making them. EP-A-0361963 (inventors Z.Z. Sheng and A.M. Hermann) discloses RTlSrCaCuO superconductors and process for making them where R is a rare earth metal. U.S. patent application Serial No. 251,349 filed September 29, 1988 in the names of Z.Z. Sheng and A.M. Hermann discloses TlSrCaCuO superconductors and processes for making same.

Despite the existence of known superconducting systems, and the fact that these patent applications disclose superconductors and methods for making them, new superconducting systems are desirable for several reasons. A new system could provide a basis for the discovery of higher-temperature superconductors. In turn, higher-temperature superconductors could provide low cost processing and manufacturing.

Thus according to a first aspect of the present invention there is provided a compound of the general formula:

$$M\text{-}R\text{-}Tl\text{-}Sr\text{-}Cu\text{-}O$$

wherein:

M represents at least one of the elements Hg, Pb, K and/or Al; and

R represents a rare earth metal.

Compounds covered by this general formula have been found to possess superconductive properties.

Preferably R represents Pr (praseodymium).

Preferably M represents lead and/or potassium. Such compounds show a Tc phase of from 93K to 100K.

M can also preferably represent mercury and/or aluminium. Such compounds often display a superconducting phase at at least 93K.

Preferred compounds have the general formula:

$$M_a\text{-}R_b\text{-}Tl_c\text{-}Sr_d\text{-}Cu_e\text{-}O_f$$

where b is about 2, c is about 3, d is about 3, e is about 3, and f is from 12 to 13. The value a is suitably from 0.5 to 1.0, in particular if M represents a single element. If M represents more than one element (for example, lead and potassium), then a can be about 1.5.

Particularly preferred compounds have the following general formula:

$$Pb_{0.5}Pr_2Tl_2Sr_3Cu_3O_{13};$$
$$HgPr_2Tl_2Sr_3Cu_3O_{13};$$
$$HgPr_2Tl_2Sr_2Cu_3O_{12}; \text{ and}$$
$$KPb_{0.5}Pr_2Tl_2Sr_3Cu_3O_{13}.$$

A second aspect of the present invention relates to a composition that preferably has superconductive properties, the composition comprising a compound of the first aspect. Suitably the composition is substantially free (such as completely free) of calcium.

A third aspect of the present invention relates to a process for the preparation of a compound of the first aspect, the process comprising admixing the appropriate elements and/or compounds containing the elements and heating. Preferably the process will involve admixing at least two compounds that contain each of the elements M, R, Tl, Sr, Cu and O. In a preferred process a compound of each of elements M, R, Tl, Cu and Sr are used, at least one of these compounds containing oxygen. The preferred compound of M is an oxide. The same is true of each of the elements R, Tl and Cu. As far as Sr is concerned, an oxide or nitrate of this element can be employed.

Thus a preferred process comprises:

(a) mixing together the appropriate elements and/or compounds containing each of the elements M, R, Tl, Sr, Cu and O, for example admixing at least one of HgO, $PbO_2$, $KO_2$ and/or $Al_2O_3$ with $R_2O_3$, $Tl_2O_3$, CuO and SrO and/or $Sr(NO_3)_2$;

(b) heating the resulting mixture; and

(c) cooling the mixture.

Preferably (a) additionally involves grinding the mixture and pressing it into a pellet.

Suitably the heating of the mixture in (b) is at a temperature of from 925 to 1,000°C, preferably 1,000°C.

Advantageously the heating in (b) is conducted in flowing oxygen.

Preferably in (c) the mixture is furnace-cooled or quenched.

In (c) during cooling the resultant compounds may be held at, for example, 650 to 750°C, such as for 5 to 6 minutes. However, it is preferred that the resultant compound is cooled to room temperature, without an isothermal hold, since this may result in a compound having a higher zero resistance temperature.

Preferred features and characteristics of one aspect of the present invention are as for another aspect *mutatis mutandis*.

The present invention in its broadest terms thus provides a composition having superconductive properties comprising M-R-Tl-Sr-Cu-O, wherein R represents a rare earth metal and M represents at least one of the elements Hg, Pb, K and/or Al.

In one embodiment, the present invention provides a compositions having superconductive properties at a temperature of approximately 93K comprising M-R-Tl-Sr-Cu-O wherein:

R represents a rare earth metal (e.g. Pr); and

M is Hg or Al.

These compounds thus form at least a 93K superconducting phase.

In another embodiment, the present invention provides a composition having a Tc of at least approximately 93K to approximately 100K. The composition may comprise M-R-Tl-Sr-Cu-O wherein:

R represents a rare earth metal such as Pr; and

M is Pb and/or K.

Suitably the invention provides a compound or material having superconductive properties having the nominal composition:

$$HgPr_2Tl_2Sr_2Cu_3O_{12};$$
$$HgPr_2Tl_2Sr_2Cu_3O_{13};$$
$$Pb_{0.5}Pr_2Tl_2Sr_3Cu_3O_{13}; \text{ or}$$
$$KPb_{0.5}Pr_2Tl_2Sr_3Cu_3O_{13}.$$

The present invention also provides methods of preparing these (high-temperature) superconductors.

The method may comprise mixing together appropriate components of the compound or composition and heating the resultant mixture.

The mixture may be heated at a temperature of approximately 1,000°C for about 5 minutes in flowing oxygen.

Suitably the mixture is pressed into a pellet prior to being heated.

Thus the present invention relates to (high-temperature) superconductors and processes for making them. To this end, the present invention provides a composition having super-conductive properties comprising the elements:

$$M\text{-}R\text{-}Tl\text{-}Sr\text{-}Cu\text{-}O$$

wherein:

M represents at least one of the elements Hg, Pb, K and/or Al; and

R represents a rare earth metal.

In a preferred embodiment, R is Pr. In other embodiments, R is Pr and M is Pb and/or K.

It has been found that particular elemental dopings with Hg, Al, Pb and/or K into a Pr-Tl-Sr-Cu-O system can result in a compound having a higher Tc. Specifically, Hg- or Al- doping produced a 93K superconducting phase, while Pb- or K- doping increased the temperature from 93K to 100K.

The present invention also provides methods for preparing such high-temperature superconductors. Samples can be prepared by mixing the appropriate components and then heating the mixture in flowing oxygen. For example, suitable compounds include $HgO$, $Al_2O_3$, $PbO_2$, $KO_2$, $R_2O_3$ (R represents a rare earth metal), $Tl_2O_3$, $SrO$ or $Sr(NO_3)_2$, and $CuO$: these can be mixed to achieve the desired composition.

In a preferred embodiment the compounds are completely mixed, ground, and pressed into a pellet having a diameter of 7mm and a thickness of 1-2mm. The pellet is then heated in a tube furnace at a temperature of approximately 1,000°C for about 5 minutes in flowing oxygen. The pellet can then be subjected to furnace-cooling or quenching.

The invention will now be described by way of example with reference to the accompanying drawings, in which:

Figure 1 is a graph of resistance versus temperature for a prior art $Pr_2Tl_2Sr_2Cu_3O_{11}$ sample (designated "A") and for a $HgPr_2Tl_2Sr_2Cu_3O_{12}$ sample of the present invention (designated "B"), both samples being prepared at 925°C;

Figure 2 is a graph of resistance versus temperature for two $HgPr_2Tl_2Sr_3Cu_3O_{13}$ samples of the present invention (designated "C" and "D"), both samples being prepared at 1,000°C;

Figure 3 is a graph of resistance versus temperature for two Pb-doped samples of the present invention with a nominal composition of $Pb_{0.5}Pr_2Tl_2Sr_3Cu_3O_{13}$; and

Figure 4 is a graph of resistance versus temperature for a $KPb_{0.5}Pr_2Tl_2Sr_3Cu_3O_{13}$ sample of the present

EP 0 475 753 A2

invention.

By way of example, and not limitation, Examples of the superconducting composition and processes for making them follow. For analysing the resultant compositions made in the examples, resistance (ac, 27 Hz was measured by a standard four-probe technique with silver paste contacts. All measurements were performed in a commercial APD refrigerator with computer control and processing.

EXAMPLE 1

A nominal $Pr_2Tl_2Sr_2Cu_3O_{11}$ Sample (A) and a nominal $HgPr_2Tl_2Sr_2Cu_3O_{12}$ Sample (B) were prepared according to the above method. The pellet was heated in a tube furnace at approximately 925°C.

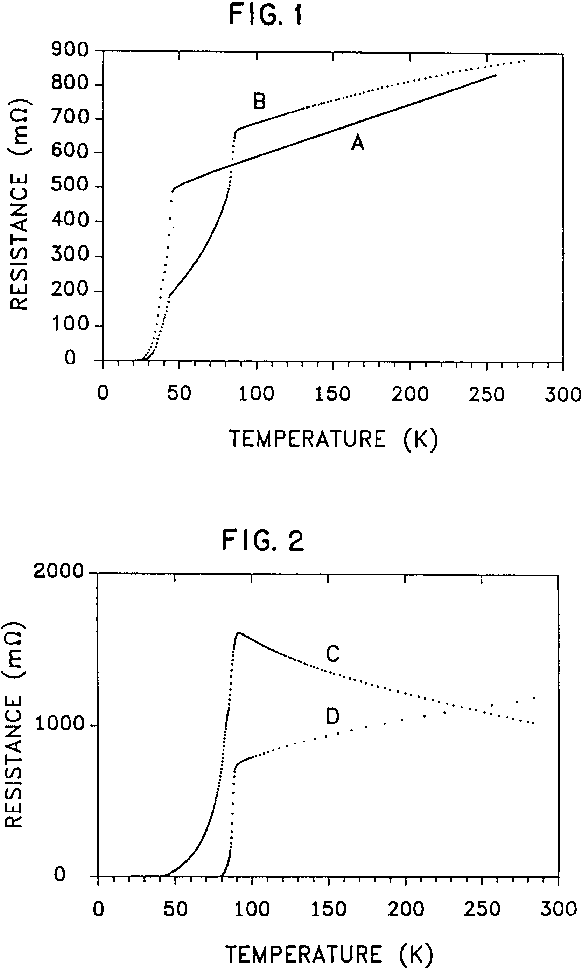

Figure 1 illustrates the resistance-temperature dependence for Sample A and Sample B. While Sample A had an onset temperature of 45K, Sample B exhibited a two-step transisition at 88K and 43K, respectively. These results indicate that the addition of HgO facilitated the formation of a new superconducting phase with higher temperatures (approximately 90K). As set forth in Example 2, the superconducting behaviour of the Hg-Pr-Tl-Sr-Cu-O samples was further enhanced by increasing the preparation temperature.

EXAMPLE 2

Two nominal $HgPr_2Tl_2Sr_3Cu_3O_{13}$ Samples (C and D) were prepared at a higher temperature, by the method previously described, except that the temperature of the furnace was heated to approximately 1,000°C. Sample C was then furnace-cooled to 700°C and remained at this temperature for 6 minutes. Sample D, on the other hand, was then furnace-cooled to room temperature.

As illustrated in Figure 2, Sample C exhibited a semi-metallic resistance-temperature behaviour at the normal state. It had an onset temperature of 93K, and a zero-resistance temperature 40K. Sample D had a similar onset temperature to Sample C, but reached zero-resistance at a much higher temperature (78K). Although not illustrated, Al-doping samples also exhibited a superconducting behaviour similar to the Hg-doping samples.

The results suggests that:

(1) either Hg or Al does not form a lattice in the superconducting phase, but only promotes the formation of the 93K superconducting phase; or

(2) Hg or Al enters into the lattice but does not influence the conductivity temperature.

EXAMPLE 3

Pb-doping Pr-Tl-Sr-Cu-O samples exhibited different superconducting behaviour as compared to the other doping elements.

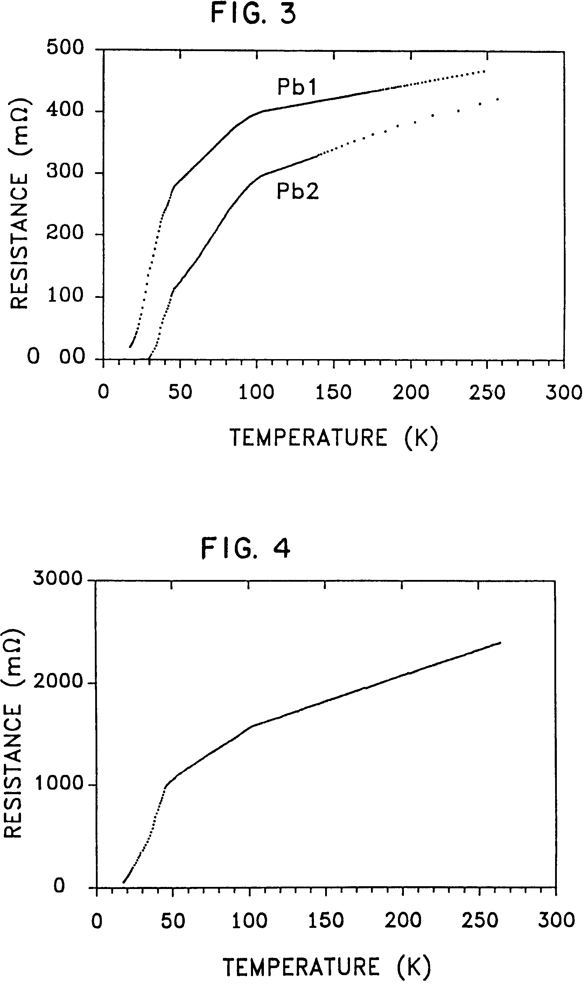

Figure 3 illustrates resistance-temperature dependence for two Pb-doping samples (Pb1 and Pb2), consisting of a nominal composition of $Pb_{0.5}Pr_2Tl_2Sr_3Cu_3O_{13}$. The samples were prepared using the method previously described.

As depicted in Figure 3, both samples demonstrated a two-step superconducting transition at approximately 100K and 45K. The superconductivity at about 100 K in these Ca-free samples was reproducible. Further, this onset temperature of around 100K was higher than other doping elements. This 100K superconducting transition was also observed in K-added Pb samples (K-Pb-R-Tl-Sr-Cu-O) as illustrated in Figure 4.

Compared with the Pr-Tl-Sr-Cu-O sample system, Pb (or Pb, K)-doping Pr-Tl-Sr-Cu-O samples do exhibit a higher superconducting temperature (about 100K). The inventors believe that these results indicate that Pb has entered the lattice structure of the superconducting phase, and has changed the superconducting behaviour of the samples. Further, the Pb-doped Pr-Tl-Sr-Cu-O samples did not contain calcium as do other superconductors with conductivity temperatures at about 100K. Accordingly, the Pb-Pr-Tl-Sr-Cu-O system may be the first Ca-free superconducting system with reproducible temperatures of about 100K.

The results also indicate that higher temperature superconductivity for Pb- and/or K-doping systems may be achieved by optimising initial compositions and preparation conditions. Moreover, further elemental substitutions in these systems may lead to higher superconducting temperatures.

**Claims**

1. A compound of the general formula:

M-R-Tl-Sr-Cu-O

4

EP 0 475 753 A2

wherein:

M represents at least one of the elements Hg, Pb, K and/or Al; and

R represents a rare earth metal.

2. A compound according to claim 1 wherein R is Pr and/or M is Pb or K.

3. A compound according to claim 1 having any of the general formulae:
   (a)    Hg-R-Tl-Sr-Cu-O
   wherein R represents a rare earth metal, that suitably forms at least a 93K superconducting phase;
   (b)    Pb-R-Tl-Sr-Cu-O
   wherein R represents a rare earth metal, that suitably has a Tc phase of from approximately 93K to 100K;
   (c)    K-R-Tl-Sr-Cu-O
   wherein R represents a rare earth metal, that suitably has a Tc phase of at least approximately 93K;
   (d)    K-Pb-R-Tl-Sr-Cu-O
   wherein R represents a rare earth metal, that suitably has a Tc of at least approximately 93K; or
   (e)    Al-R-Tl-Sr-Cu-O
   wherein R represents a rare earth metal, that suitably forms at least a 93K superconducting phase.

4. A compound according to claim 3 wherein R is Pr.

5. A process for the preparation of a compound of the general formula
   $$M-R-Tl-Sr-Cu-O$$
   wherein:
   M represents at least one of the elements Hg, Pb, K and/or Al; and
   R represents a rare earth element;
   the process comprising admixing the appropriate elements and/or compounds containing the elements and heating.

6. 6. A process as claimed in claim 5 wherein the process comprises:
   (a) mixing together at least one of HgO, $PbO_2$, $KO_2$ and/or $Al_2O_3$ with $R_2O_3$ (wherein R represents a rare earth metal), $Tl_2O_3$, CuO and SrO and/or $Sr(NO_3)$;
   (b) heating the resultant mixture; and
   (c) cooling the mixture.

7. A process according to claim 6 wherein the mixture in (a) is ground and pressed into a pellet.

8. A process according to claim 6 or 7 wherein the heating of the mixture in (b) is at a temperature of approximately 1,000°C for about five minutes.

9. A process according to any of claims 6 to 8 wherein the mixture in (b) is heated in flowing oxygen.

10. A process according to any of claims 6 to 9 wherein the mixture in (c) is quenched.

**Claims for the following Contracting States : ES**

1. A process for the preparation of a compound of the general formula
   $$M-R-Tl-Sr-Cu-O$$
   wherein:
   M represents at least one of the elements Hg, Pb, K and/or Al; and
   R represents a rare earth element;
   the process comprising admixing the appropriate elements and/or compounds containing the elements and heating.

2. A process as claimed in claim 1 wherein the process comprises:
   (a) mixing together at least one of HgO, $PbO_2$, $KO_2$ and/or $Al_2O_3$ with $R_2O_3$ (wherein R represents a rare earth metal), $Tl_2O_3$, CuO and SrO and/or $Sr(NO_3)$;
   (b) heating the resultant mixture; and

5

(c) cooling the mixture.

3. A process according to claim 2 wherein the mixture in (a) is ground and pressed into a pellet.

4. A process according to claim 2 or 3 wherein the heating of the mixture in (b) is at a temperature of approximately 1,000°C for about five minutes.

5. A process according to any of claims 2 to 4 wherein the mixture in (b) is heated in flowing oxygen.

6. A process according to any of claims 2 to 5 wherein the mixture in (c) is quenched.

7. A process as claimed in any of claims 1 to 6 wherein R is Pr.

8. A process as claimed in any of claims 1 to 7 for preparing a compound having any of the following general formula:
   (a)      Hg-R-Tl-Sr-Cu-O
   wherein R represents a rare earth metal, that suitably forms at least a 93K superconducting phase;
   (b)      Pb-R-Tl-Sr-Cu-O
   wherein R represents a rare earth metal, that suitably has a Tc phase of from approximately 93K to 100K;
   (c)      K-R-Tl-Sr-Cu-O
   wherein R represents a rare earth metal, that suitably has a Tc phase of at least approximately 93K;
   (d)      K-Pb-R-Tl-Sr-Cu-O
   wherein R represents a rare earth metal, that suitably has a Tc of at least approximately 93K; or
   (e)      Al-R-Tl-Sr-Cu-O
   wherein R represents a rare earth metal, that suitably forms at least a 93K superconducting phase.

9. A process as claimed in any of claims 1 to 8 for preparing the compound:
$$Pb_{0.5}Pr_2Tl_2Sr_3Cu_3O_{13},$$
$$HgPr_2Tl_2Sr_3Cu_3O_{13},$$
$$HgPr_2Tl_2Sr_2Cu_3O_{11}, \text{ or}$$
$$KPb_{0.5}Pr_2Tl_2Sr_3Cu_3O_{13}.$$

# FIG. 1

# FIG. 2

## FIG. 3

## FIG. 4